# EUROPEAN PATENT APPLICATION

(11) **EP 1 542 275 A1**
(43) Date of publication of application: **15.06.2005**
(21) Application number: 03293102.4
(22) Date of filing: 10.12.2003
(51) Int. Cl.: H01L 21/762

(54) **A method for improving the quality of a heterostructure**

(71) Applicant: S.O.I.TEC. Silicon on Insulator Technologies S.A., 38190 Bernin (FR); COMMISSARIAT A L'ENERGIE ATOMIQUE, 75752 Paris Cédex 16 (FR)
(72) Inventor: Blondeau, Beryl, 38700 La Tronche (FR); Cayrefourcq, Ian, 38330 St.Nazaire les Eymes (FR); Guiot, Eric, 38570 Goncelin (FR); Maurice, Thibaut, 38100 Grnoble (FR); Moriceau, Hubert, 38120 Saint Egrève (FR)
(74) Representative: Grünecker, Kinkeldey, Stockmair & Schwanhäusser Anwaltssozietät

(57) **Abstract**

The present invention relates to a method for improving the quality of a heterostructure, consisting of at least two materials with different thermal expansion coefficients, which are connected together, the method comprising an annealing step of the heterostructure. It is the object of the present invention to provide a reliable and more effective method for improving the quality of a heterostructure. The object is solved by a method of the above-mentioned type characterised in that at least one cap layer is brought onto the heterostructure before the annealing step and the annealing step is performed on the heterostructure with the cap layer.

## Description

The present invention relates to a method for improving the quality of a heterostructure, consisting of at least two materials with different thermal expansion coefficients, which are connected together, the method comprising an annealing step of the heterostructure.

Heterostructures can be silicon-on-quartz (SOQ), SiGe-on-silicon, germanium-on-silicon, silicon carbide-on-silicon or III-V-semiconductors-on-silicon structures. Especially such heterostructures which have a thin layer of one material bonded on a substrate of another material are very attractive for micro-electronics and optoelectronics. An additional layer, for example an insulator layer, can be inserted between the layer and the substrate.

Heterostructures may be formed by a detachment technique such as splitting of a hetero-bonded structure by a so-called Smart-cut® process. The split surface of these heterostructures is relatively rough, so that it is often necessary to finish that surface after splitting. In addition, the bonding interface needs to be improved and the implantation defects should be removed.

One approach to finishing a split surface of a SOI structure is described in WO 01/15215 A1. In a first step, the heterostructure is annealed by a rapid thermal annealing process with a maximum temperature of about 1200° to 1230°C resulting in a decreased roughness and improved bonding strength. To obtain a lower roughness of that surface, it is treated in a further step by a chemical-mechanical polishing.

Using this method for fabricating heterostructures, it has been shown that temperatures over a few hundred °C result in a formation of process-induced defects of the heterostructure such as grid defects, while temperatures below about a few hundred °C do not lead to sufficient bonding strength.

Grids or slip lines or other crystal defects which are the size of a few atomic planes and are formed at the surface and/or at a bonding interface of an overheated heterostructure render the structure unusable for most tasks. HF-defects are defects that can be observed by using a HF-solution, making the defects visible. HF-defects are in an order of about 0.1 to 0.5 microns.

The above-mentioned damages may result from and/or are amplified by the thermally induced stress of the heterostructure caused by the difference in the thermal expansion coefficients of the materials of the heterostructure.

It is therefore the object of the present invention to provide a reliable and more effective method for improving the quality of a heterostructure.

The object is solved by a method of the above-mentioned type characterised in that at least one cap layer is brought onto the heterostructure before the annealing step, and the annealing step is performed on the heterostructure with the cap layer.

Experiments have shown that the presence of a cap layer results in fewer thermally-induced defects. The capacity to use high temperatures in the annealing step makes it possible to obtain high quality heterostructures with an increased stability due to a high bonding force between the materials of the heterostructure and/or to reduce defect density of the heterostructure. Using a cap layer applied to SOQ-wafers reduces HF defect density under thermal treatment.

In a special embodiment of the present invention, the cap layer is brought onto a top surface of the heterostructure formed by a layer transfer technique, especially by implantation, direct bonding and detachment. By this method, the cap layer can be used to improve the quality of the heterostructure, particularly the defect density of its top layer. During thermal treatment, the cap layer protects the surface of the top layer, so that a chemical reaction such as a thermal oxidation or another influence of the annealing atmosphere on the top layer can be reduced.

In a favourable example of the invention, at least one silicon dioxide layer and/or at least one silicon nitride layer is brought onto the heterostructure as the cap layer. The use of silicon dioxide and/or silicon nitride allows an easy and effective protection of the heterostructure, to reduce a formation of defects by the annealing step.

In a preferable embodiment of the invention, the cap layer is brought onto the heterostructure using a film deposition technique selected from a group comprising plasma-enhanced chemical vapour deposition, magnetron sputtering and ion-assisted electron beam separation. These deposition techniques are very well-suited to form a cap layer on the heterostructure in an easy but defined way.

It is furthermore advantageous when the annealing step is performed at a temperature of about 500°C to about 1200°C. This method has the advantage that through a temperature treatment in this temperature region a very high quality of the crystallinity and/or the surface characteristics of the heterostructure can be obtained. Furthermore, the bonding force between the materials of the heterostructure can be increased.

According to another beneficial embodiment of the invention, the cap layer is removed after the annealing step. In this manner, the heterostructure can be uncovered but maintains its improved quality.

In a yet further favourable variant of the invention, the cap layer is removed by at least one technique selected from a group comprising chemical-mechanical polishing, dry etching or wet etching. By these techniques, the cap layer can be removed efficiently with little or no influence on the quality of the uncovered heterostructure.

In yet another advantageous embodiment of the invention, a surface of the heterostructure is polished before the cap layer is brought onto said surface. The polishing step results in a flat surface of the heterostructure wherein slight eventual polishing defects of the surface can be reduced with less risk of a thermal oxidation of the polished surface, due to the protecting cap layer on that surface.

In a specific example of the invention, the cap layer is composed of at least two sub-layers, especially a SiO₂ and a Si₃N₄ layer. The materials and properties of the sub-layers can be adjusted to the desired effect to be obtained. SiO₂ and Si₃N₄ layers are specifically advantageous for the method and help to reduce HF defect density under thermal treatment.

Specific embodiments of the present invention will become more apparent from the following detailed description with reference to the accompanying drawings, in which:
- Fig. 1 through Fig. 4: schematically show an example for providing a heterostructure according to an embodiment of the present invention;
- Fig. 5 and Fig. 6: schematically show examples of heterostructures used in embodiments of the present invention;
- Fig. 7 through Fig. 10: schematically show examples of heterostructures onto which at least one cap layer is brought, according to the present invention;
- Fig. 11: schematically shows an annealing step according to an embodiment of the present invention;
- Fig. 12 and Fig. 13: schematically show resulting heterostructures according to embodiments of the present invention.

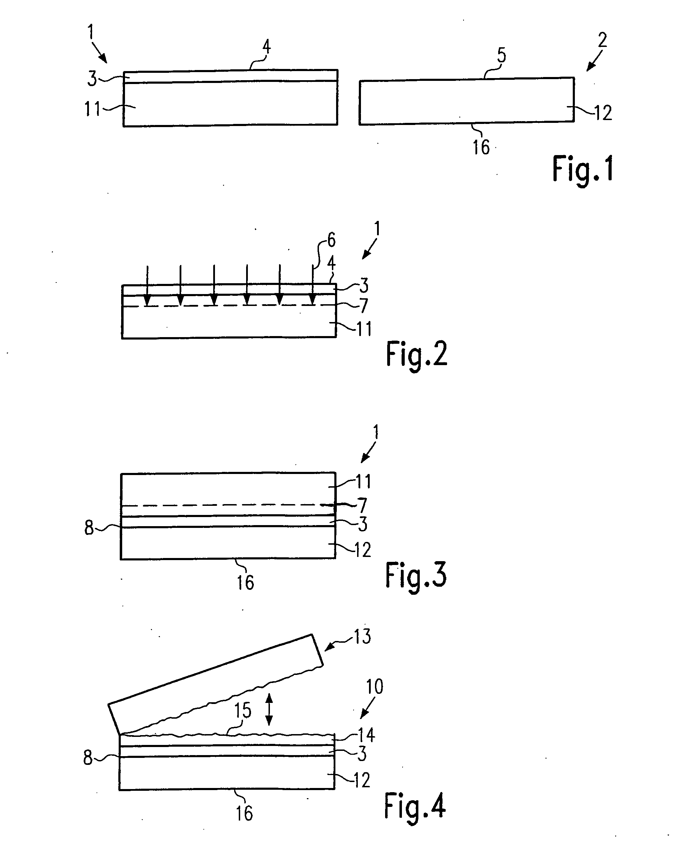

Figs. 1 through 4 schematically show an exemplary process flow for producing a heterostructure 10, according to an embodiment of the present invention.

With reference to Fig. 1, a wafer 1 and a wafer 2 are provided. Wafer 1 comprises a substrate 11 of a material different from a material of a substrate 12 of the wafer 2. In particular, the substrates 11 and 12 comprise materials with different thermal expansion coefficients. The material of the substrates 11 and 12 can be of silicon, germanium, silicon carbide, silicon dioxide, fused silica, III-V-semiconductors or other materials which are suitable for forming heterostructures. For instance, wafer 1 may be composed of a support substrate on which one or more layers of semiconductor material (SiGe, Ge, GaN, AsGa) are deposited. Although not absolutely necessary, the wafer 1 of the embodiment shown comprises an auxiliary layer 3 of a material such as silicon dioxide on top of the substrate 11.

The wafers 1, 2 have surfaces 4, 5 which are later brought together.

As shown in Fig. 2, the wafer 1 is implanted with species 6 such as hydrogen ions, which concentrate through the surface 4 and the auxiliary layer 3 at a certain depth of the substrate 11 to form in a region at or near the maximum of concentration, a pre-determined weakened area 7.

Referring to Fig. 3, the implanted wafer 1 shown in Fig. 2 and the wafer 2 of Fig. 1 are bonded together at their surfaces 4, 5. This bonding step results in a heterostructure 9 with a bonding interface 8.

In an ensuing step, shown in Fig. 4, the bonded heterostructure 9 of Fig. 3 is split into two structures 10, 13 along the pre-determined weakened area 7 of Fig. 3. The first split structure 10 is a heterostructure consisting of the thick substrate 12 of the former wafer 2, the auxiliary layer 3 and a transferred part 14 of the substrate 11 of the former wafer 1. The transferred part forms a thin top layer 14 of the heterostructure 10 which has a thermal expansion coefficient different from that of the substrate 12. The top layer 14 forms an active part of the heterostructure. Due to splitting, the top layer 14 has a relatively rough surface 15. This surface roughness is disadvantageous for a further use of the heterostructure 10.

The heterostructure 10 has a back side 16 which corresponds to the back side 16 of the original wafer 2.

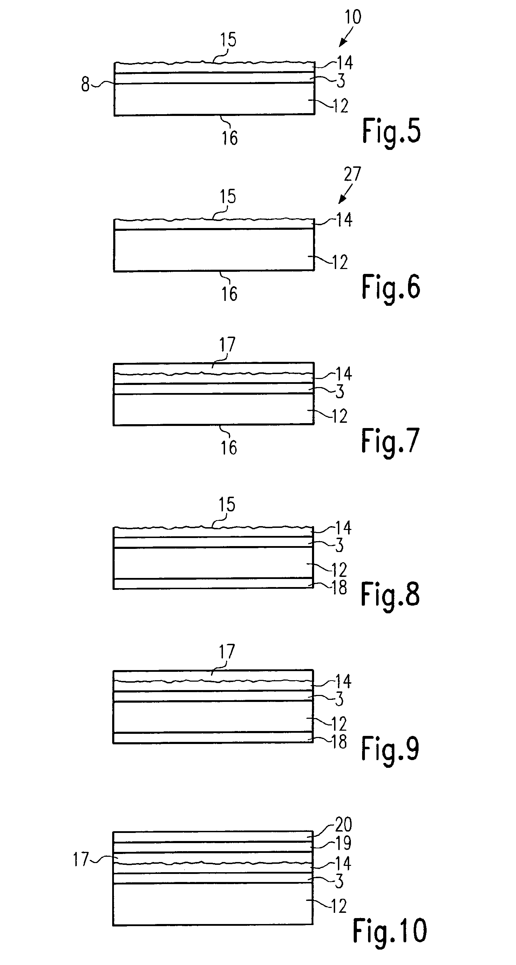

Fig. 5 schematically shows the heterostructure 10 of Fig. 4 after its separation from the residual part 13.

In Fig. 6, another embodiment for a heterostructure 27 is shown which can be used in the present invention. The heterostructure 27 consists of a substrate 12 and a top layer 14 with a surface 15 of increased roughness in the embodiment shown. In other embodiments of the invention, the heterostructures 10, 27 can comprise one or more additional layers in accordance with the corresponding intended uses of the heterostructures.

Further, it is not absolutely necessary that the heterostructures 10, 27 have been formed by a splitting method as shown in Figs. 1 through 4. The heterostructures 10, 27 can also be formed by another layer transfer technique or by a growing or a deposition technique, in which at least two materials with different thermal expansion coefficients are connected together. This connection can be any adhering mechanism including bonding, physical and/or chemical adhering mechanisms, gluing or welding.

The surface 15 of the split top layer 14 can be polished to decrease the roughness of the surface 15. The polished surface 15 can have slight polishing defects.

The heterostructure 10, 27 can be a SOQ (silicon-on-quartz) structure, a SiGe-on-Si structure, a Ge-on-Si structure, a SiC-on-Si structure, a III-V-semiconductor-on-silicon structure or another material compound. In the embodiment shown in Fig. 6, the heterostructure 27 is a SOQ-structure consisting of a silicon layer 14 of about 200nm thickness on a substrate 12 of fused silica, made by a Smart-cut® process. An additional layer, for example an insulator layer, can be inserted between the thin top layer and the substrate.

Due to the different thermal expansion coefficients of the materials of the heterostructure 10, 27, a stress is present in this structure during thermal treatments, which is particularly localised inside the top layer 14 and/or the bonding interface 8. With reference to the heterostructure 27, the silicon layer 14 is in a compressive state at the interface 8 due to its thermal coefficient mismatch in relation to the substrate 12 of fused silica.

The stress appears and increases when higher temperatures are applied to the heterostructure 10, 27. If a certain stress limit is exceeded, a formation of defects like HF defects can appear. The HF defect density of the exemplary SOQ-structure 27 with the 200 nm thick silicon layer 14, after thermal treatment at about 950°C, is between about 24 and 40 cm⁻².

To prevent such effects, the heterostructure 10 of Fig. 5 is covered by a cap layer 17 which is brought directly onto the rough surface 15 of the top layer 14 formed by splitting, as shown in Fig. 7. The material and the thickness of the cap layer 17 are adapted for instance to the thickness relationship and the difference of thermal expansion coefficients of the materials of the heterostructure 10, to prevent defects.

The cap layer may also be deposited on the back side of the heterostructure to simplify the process or to compensate for the stress imparted on the heterostructure by the single top cap layer.

Fig. 10 shows yet another embodiment of the present invention, in which several cap layers 17, 19, 20 are brought onto the top layer side of the heterostructure 10. Preferably, at least the cap layer 19 is of a material other than that of the other cap layers 17 and 20.

In a preferable embodiment of the invention, the cap layer(s) 17, 18, 19, 20 shown in Figs. 7 through 10 are of silicon dioxide and/or silicon nitride and/or oxynitrides (SiON). For example, the cap layer(s) may consist of a layer sequence of 50 nm SiO₂ and 50 nm Si₃N₄, of 100 nm SiO₂ and 50 nm Si₃N₄, of 100 nm SiO₂, 50 nm Si₃N₄ and 100 nm SiO₂ or of other favourable layer sequences including a single layer such as a 50 nm thick Si₃N₄ layer or a 1000 nm thick SiO₂ layer.

The cap layers 17, 18, 19, 20 can be deposited by a plasma-enhanced chemical vapour deposition (PE-CVD) performed in a reactor at temperatures up to about 400°C. The thickness and the characteristics of a layer deposited in this way can be adjusted via the RF power of the plasma in the reactor, the pressure of the gases used, such as SiH₄ and NH₃, the proportion of the gases used and the deposition temperature and time.

In a PE-CVD deposition, the frequency of the RF power can be varied to influence the deposition and the characteristics of the deposited layer. Typically, the RF frequency for a high-frequency domain is about 13.56 MHz, and can be in a mid-frequency range of about 1 to 4 MHz, and in a low-frequency range of about 80 and 500 kHz.

Furthermore, the bias current at the back face of the heterostructure can be used as a parameter in a PE-CVD process.

Favourable parameters for PE-CVD deposition of a SiO₂ cap layer with a thickness of about 50nm are the following:

The temperature of the plasma can be adjusted to be about 400°C. The thickness of the deposited layer is mainly controlled by the deposition time, which can be of a few seconds. Further favourable parameters of a SiO₂ deposition are an RF power of about 200W and a chamber pressure of about 2.5 Torr. The gases used are typically SiH₄ and N₂O.

Typical parameters for a PE-CVD deposition of a Si₃N₄-cap layer with a thickness of about 50nm are the following:

The temperature of the plasma should be about 400°C. As a deposition time, a few seconds are sufficient. An RF power of about 625W and a chamber pressure of about 5 Torr are advantageous. The used gases are SiH₄, N₂ and NH₃.

The characteristics of the deposited layer is controlled by the summary of all parameters used during the deposition process, such as the kind of deposition, the material used, the pressure, the proportion, the dilution and the nature of the used gases, the applied temperatures, the bias current, the RF frequency.

In a further embodiment of the invention, the cap layer 17, 18, 19, 20 is deposited by a physical vapour deposition like magnetron sputtering. In this method, the thickness and the characteristics of the deposited material are adjusted with the RF power of the plasma, the nature, the pressure and the proportion of the gases used, such as SiH₄ and NH₃, and also with the bias current and the temperature of the substrate.

In another variant of the invention, the cap layers 17, 18, 19, 20 can be formed by a UHV ion-assisted electron beam deposition. To obtain a certain layer thickness and certain characteristics of the deposited layer, the ion energy and the substrate temperature are controlled in this method.

The cap layer 17, 18, 19, 20 can act as a diffusion barrier to prevent a diffusion of reactants of the annealing atmosphere into the heterostructure 10, 27 and in particular into the thin top layer 14.

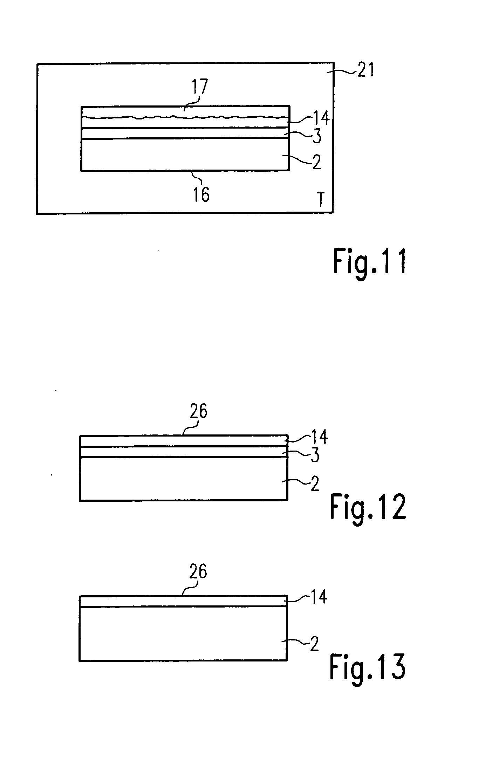

As shown exemplarily in Fig. 11, a cap layer-covered heterostructure, such as a structure shown in Figs. 7 through 10, is annealed in a furnace 21. Instead of a furnace annealing, any other thermal treatment can be applied which leads to a warming up of a cap layer-covered heterostructure. For example a photonic, rapid thermal processing or a laser treatment can be applied, or microwaves.

Thermal treatment is favourably made in a temperature region from about 500°C to about 1200°C, typically over a period of between about 1 to 4 hours. Tests which have been performed at 950°C, 1020°C or 1100°C resulted in very low HF defect densities of capped SOQ-structures after annealing, such as densities of about 5 down to about 0.3 HF defects per cm². In a temperature region of about 750° to 1000°C no formation of defects could be observed.

Advantageous environments for thermal treatment can comprise pure Ar or ArO₂ and O₂.

The inventive high temperature annealing leads to non-degradation of the crystal quality and/or the surface quality of the layer 14.

In heterostructures 10, 27 in which a split surface 15 has been polished before the deposition of the cap layer 17, 19, 20 on top of the polished surface 15, slight polishing defects induced by the polishing step are reduced due to thermal annealing.

When the cap layer 17, 19, 20 is brought on top of the top layer 14, the top layer 14 is protected by the cap layer 17, 19, 20 so that a thermal oxidation or another chemical reaction or physical influence on the surface induced by the atmosphere can be prevented.

Due to the high temperatures used in the annealing step, the bonding force between the top layer 14 and the substrate 12 can be enhanced.

As shown in Figs. 12 and 13, after the annealing step shown in Fig. 11 the at least one cap layer 17, 18, 19, 20 is removed. This can be done by a chemical-mechanical polishing, a dry etching or a wet etching, with which methods the at least one cap layer 17, 18, 19, 20 can be effectively removed with little or no effect on the quality of the heterostructure.

As shown in particular in Figs. 12 and 13, the resulting surface 26 of the layer 14 has an improved surface roughness and is free of thermal-induced defects like grids. In the heterostructures of Figs. 12 and 13, the top layer 14 lies uncovered on top of the respective structures, so that these structures are transparent for further processing.

## Claims

1. A method for improving the quality of a heterostructure (10, 27) consisting of at least two materials (1, 2) with different thermal expansion coefficients which are connected together, the method comprising an annealing step of the heterostructure (10, 27), **characterised in that** at least one cap layer (17, 18, 19, 20) is brought onto the heterostructure (10) before the annealing step, and the annealing step is performed on the heterostructure (10, 27) with the cap layer (17, 18, 19, 20).

2. The method of claim 1 **characterised in that** the cap layer (17, 19, 20) is brought onto a top surface (15) of the heterostructure (10, 27), formed by a layer transfer technique, especially by implantation, direct bonding and detachment.

3. The method of at least one of the preceding claims **characterised in that** at least one silicon dioxide layer and/or at least one silicon nitride layer is brought onto the heterostructure (10, 27) as the cap layer (17, 18, 19, 20).

4. The method of at least one of the preceding claims **characterised in that** the cap layer (17, 18, 19, 20) is brought onto the heterostructure (10, 27) using a film deposition technique selected from the group consisting of plasma-enhanced chemical wafer deposition, magnetron sputtering and ion-assisted electron beam deposition.

5. The method of at least one of the preceding claims **characterised in that** the annealing step is performed at a temperature of about 500°C to about 1200°C.

6. The method of at least one of the preceding claims **characterised in that** the cap layer (17, 18, 19, 20) is removed after the annealing step.

7. The method of claim 6 **characterised in that** the cap layer (17, 18, 19, 20) is removed by at least one technique selected from the group consisting of chemical-mechanical polishing, dry etching or wet etching.

8. The method of at least one of the preceding claims **characterised in that** a surface (15, 16) of the heterostructure (10, 27) is polished before the cap layer (17, 18, 19, 20) is brought onto said surface (15, 16).

9. The method of at least one of the preceding claims **characterised in that** the cap layer is composed of at least two sub-layers, especially a SiO₂ and a Si₃N₄ layer.
